# EUROPEAN PATENT APPLICATION

(11) **EP 2 532 696 A1**
(43) Date of publication of application: **12.12.2012**
(21) Application number: 10845035.4
(22) Date of filing: 05.02.2010
(51) Int. Cl.: C08G 61/12, C09K 11/06

(54) **CONJUGATED FLUORENE POLYMER, PREPARING METHOD THEREOF AND SOLAR BATTERY COMPONENT**

(71) Applicant: Ocean's King Lighting Science&Technology Co., Ltd., Guangdong 518054 (CN)
(72) Inventor: ZHOU, Mingjie, Shenzhen Guangdong 518054 (CN); HUANG, Jie, Shenzhen Guangdong 518054 (CN); LIU, Hui, Shenzhen Guangdong 518054 (CN)
(74) Representative: Michalski, Stefan
(86) International application number: PCT/CN2010/070551
(87) International publication number: WO 2011/094950

(57) **Abstract**

A conjugated fluorene polymer is provided, which is defined by structure formula (1), wherein: R₁, R₂, R₃, R₄ represent H or C₁-C₂₀ alkyl, x+y=1, x≠0, y≠0, n is a natural number between 1-1000, Ar₁ is a group containing thiophene. A preparation method for the conjugated fluorene polymer and a solar cell device containing the conjugated fluorene polymer are also provided. Due to fluorene or its derivatives and conjugated structure, the conjugated fluorene polymer exhibits an excellent light stability and thermal stability. In addition, since thiophene and benzothiadiazole groups are introduced into the main chain of the polymer, the spectral response range of the polymer is broadened.

## Description

### FIELD OF THE INVENTION

The present disclosure relates to organic materials, and more particularly relates to a conjugated fluorene polymer, a preparing method thereof and a solar cell device.

### BACKGROUND OF THE INVENTION

Today's world economy is mainly based on fossil energy, such as coal, oil and natural gas. However, these non-renewable fossil energy are becoming exhausted. Since the beginning of the 21st century, global energy issues, the consequent environmental pollution and global warming become increasingly apparent and intense. Solar energy has numerous advantages such as the broad and widespread distribution, large resource quantity, no pollution, clean, safety and convenient access, therefore it is considered to be one of the most promising renewable sources of energy.

To take full advantage of the solar energy radiated from the sun, people continue to develop new materials to absorb sunlight, in which inorganic semiconductor materials, such as silicon cells used on the ground, has gained broader development and application. However, due to their complex process and high cost, the application of the silicon cells has been strictly limited. In order to reduce costs and expand the application scope, people have been looking for new alternative semiconductor materials for a long period of time.

In recent years, organic materials have gradually gained widespread interest. For example, after the report of photo-induced electron transfer phenomena between conjugated polymers and C₆₀ by N. S. Sariciftci in 1992, people have put lots of research on conjugated polymer used in the solar cell, and have achieved rapid development. Solar cells directly transform solar energy into electric energy, which is an effective method of using solar energy.

Organic solar cell is a new type of solar cell. Compared with the disadvantages of the inorganic semiconductor materials such as limited sources, high prices, toxicity, complicated preparation process, high cost, the organic solar cell has some advantages such as wide range of materials, structural diversity and manageability, low cost, safety and environmental protection, simple production process, light weight of product, flexible preparation for large area, etc., thus it has important developing and applicable prospects and can be widely used in the fields of architecture, illumination and power generation. However, photoelectric conversion efficiency of organic solar cells is much lower than that of inorganic solar cells for now. Therefore, the development of new organic materials is of great significance for improving the efficiencies of organic solar cells and other semiconductor devices or optoelectronic devices.

### SUMMARY OF THE INVENTION

In one aspect of the present disclosure, a conjugated fluorene polymer is provided having a wide spectral response and good stability, and a preparation method for the conjugated fluorene polymer is also provided having a simple synthetic route and a low cost.

In another aspect of the present disclosure, a solar cell device including the conjugated fluorene polymer is also provided.

A conjugated fluorene polymer includes a polymer represented by formula (1): 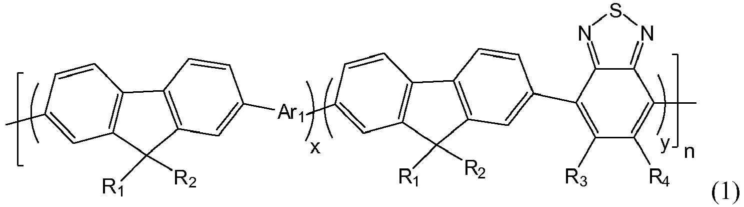 wherein R₁, R₂, R₃, R₄, which may be identical or different, represent H or C₁-C₂₀ alkyl, x+y=1, x≠0, y≠0, n is a natural number between 1-1000, Ar₁ is a group containing thiophene.

A preparation method of a conjugated fluorene polymer, includes the steps of:

providing compounds A, B, C, and D represented by formulas: 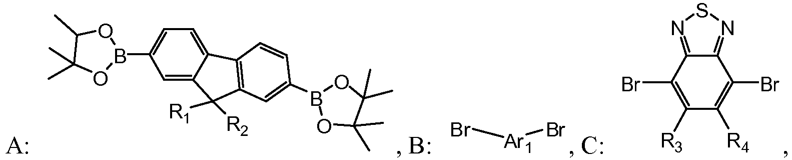 wherein R₁, R₂, R₃, R₄, which may be identical or different, represent H or C₁-C₂₀ alkyl, x+y=1, x≠0, y≠0, Ar₁ is a group containing thiophene;

Suzuki polymerizing the compounds A, B and C in the presence of a catalyst, a solvent and an alkaline solution to obtain a polymer represented by formula (1): 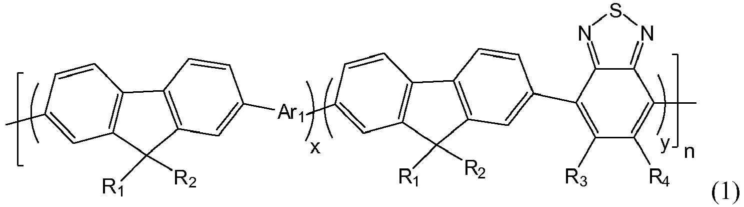 wherein n is a natural number between 1-1000.

A solar cell device includes a glass substrate, a transparent anode, a middle auxiliary layer, an active layer and a cathode, which are laminated in this order, the active layer comprising electron donor materials and electron acceptor materials, wherein the electron donor material is the conjugated fluorene polymer described above.

In the conjugated fluorene polymer, the fluorene or its derivatives have excellent optical and thermal stability. Since the thiophene groups are introduced in the polymer main chain, and the thiophene has a five-membered ring structure, which matches the Huckel rule and has moderate energy band gap, wide spectral response, better thermal stability and environmental stability, the spectral response range of the polymer becomes wider. Meanwhile, benzothiadiazole groups, which have a five-membered ring structure and a conjugated dienes structure, are introduced in the polymer main chain. The benzothiadiazole groups not only can have similar performance of the thiophene, but also can function as a conjugated dienes structure, thus further widen the spectral response range of the polymer. In addition, these introduced groups have a large ring and/or fused ring structure, thus they can increase the electron density of the polymer backbone, such that the absorption spectrum of the conjugated fluorene polymer can be adjusted in a wide range, which makes such materials can have a wider spectral response range. When the polymer is applied to optoelectronic materials, they can better match the solar emission spectrum, and make full use of solar energy. In the preparation method of the conjugated fluorene polymer, a relatively simple synthetic route (basically a step synthesis) is used, thereby reducing the process and the manufacturing costs. Due to the use of the conjugated fluorene polymer, the solar cell device can not only increase the photoelectric conversion efficiency, but also can reduce the weight of solar cell devices, and thus facilitating the mass production.

### BRIEF DESCRIPTION OF THE DRAWINGS

The components in the drawings are not necessarily drawn to scale, the emphasis instead being placed upon clearly illustrating the principles of the present disclosure. Moreover, in the drawings, like reference numerals designate corresponding parts throughout the views.

FIG. 1 illustrates a formula of an embodiment of a conjugated fluorene polymer;

FIG. 2 a flowchart of an embodiment of a method for preparing the conjugated fluorene polymer;

FIG. 3 illustrates an embodiment of a solar cell device including the conjugated fluorene polymer.

### DETAILED DESCRIPTION

The disclosure is illustrated by way of example and not by way of limitation in the figures of the accompanying drawings in which like references indicate similar elements. It should be noted that references to "an" or "one" embodiment in this disclosure are not necessarily to the same embodiment, and such references mean at least one.

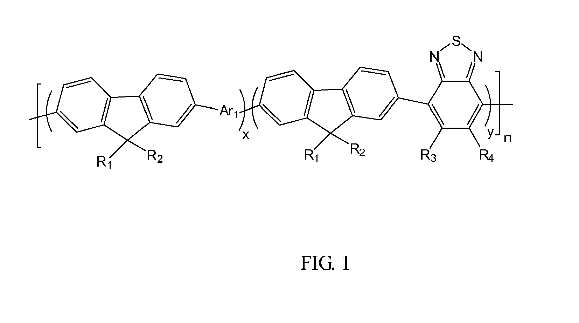

Referring to FIG. 1, an embodiment of a conjugated fluorene polymer includes a polymer represented by formula (1): 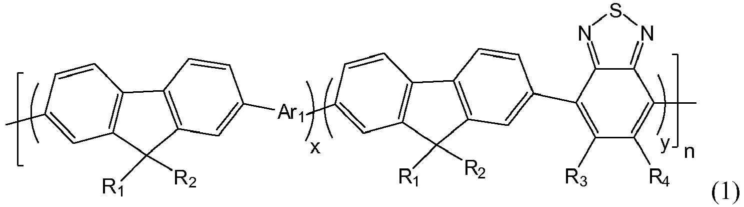 wherein R₁, R₂, R₃, R₄, which may be identical or different, represent H or C₁-C₂₀ alkyl, x+y=1, x≠0, y≠0, n is a natural number between 1-1000, Ar₁ is a group containing thiophene.

In embodiments of the present disclosure, a range of x and y is preferably shown as: x=20%-80%, y=20%-80%. In a more preferable embodiment, x and y are both 50%. R₁ and R₂ may be identical linear alkyl, preferably are C₈H₁₇, i.e. octyl or isomer of the octyl, and preferably are octyl. R₃ and R₄ are both H. The n are preferably 30-800, more preferably 50-500.

In embodiments of the present disclosure, Ar₁ is selected from the group consisting of the following formulas: 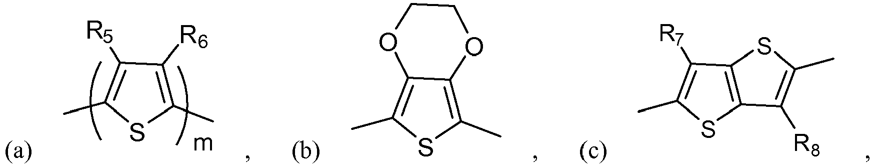 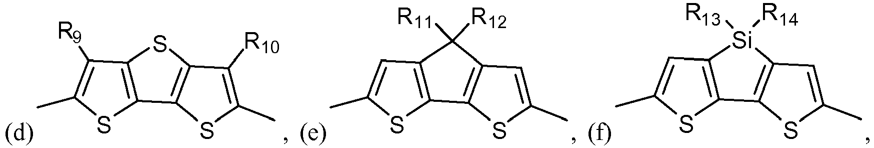 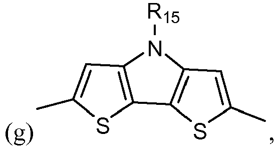 wherein R₅, R₆, R₇, R₈, R₉, R₁₀, which may be identical or different, represent H or C₁-C₂₀ alkyl; and R₁₁, R₁₂, R₁₃, R₁₄, R₁₅, which may be identical or different, represent H or C₁-C₂₀ alkyl; m is a natural number between 1-20. Preferably, R₅, R₆, R₇, R₈, R₉, R₁₀, which may be identical or different, represent H or C₁-C₆ alkyl. R₁₁, R₁₂, R₁₃, R₁₄, R₁₅, which may be identical or different, represent C₁-C₆ alkyl, the m is a natural number between 2-20. In a preferable embodiment, Ar₁ is the group represented by the formula (c), R₇ and R₈ are preferably H, i.e. Ar₁ is -C₆H₂S₂-.

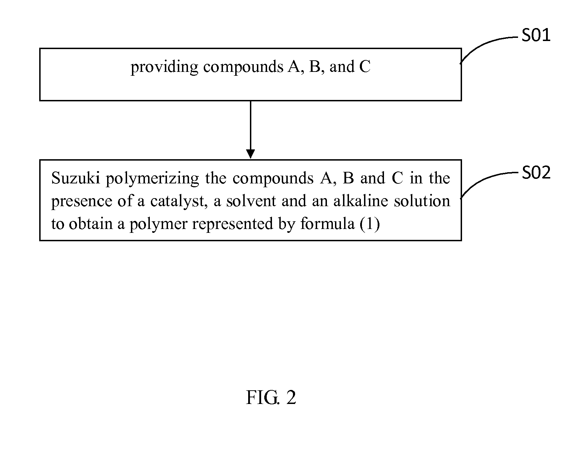

Referring to FIG. 2, an embodiment of preparation method of the conjugated fluorene polymer described above includes the following steps:

S01: compounds A, B, and C represented by following formulas are provided: 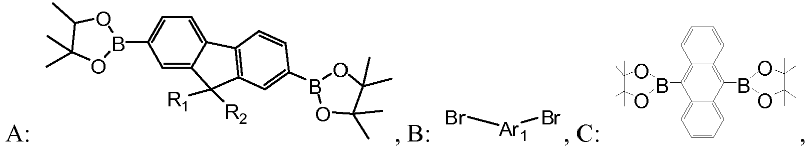 wherein R₁, R₂, R₃, R₄, which may be identical or different, represent H or C₁-C₂₀ alkyl, x+y=1, x≠0, y≠0, Ar₁ is a group containing thiophene.

S02: the compounds A, B and C are Suzuki polymerized in the presence of a catalyst, a solvent and an alkaline solution to obtain a polymer represented by formula (1) 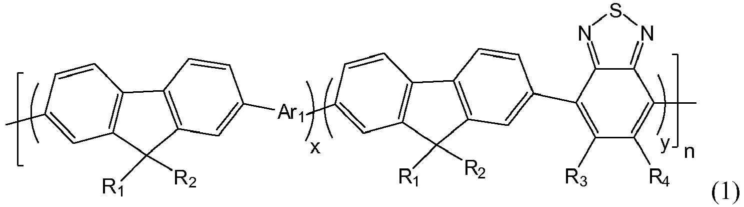 wherein n is a natural number between 1-1000.

In step S01, the compounds A, B, and C can be directly purchased from the market or prepared according to conventional synthesis method. As previously described, x=20%-80%, y=20%-80%. In a more preferable embodiment, x and y are both 50%. R₁ and R₂ may be identical linear alkyl, preferably are C₈H₁₇, i.e. octyl or isomer of the octyl, and preferably are octyl. R₃ and R₄ are both H. The n are preferably 30-800, more preferably 50-500.

As previously described, Ar₁ is selected from the group consisting of following formulas (a) - (g). Preferably, R₅, R₆, R₇, R₈, R₉, R₁₀, which may be identical or different, represent H or C₁-C₆ alkyl. R₁₁, R₁₂, R₁₃, R₁₄, R₁₅, which may be identical or different, represent C₁-C₆ alkyl, the m is a natural number between 2-10. In a preferable embodiment, Ar₁ is the group represented by the formula (c), R₇ and R₈ are preferably H, i.e. Ar₁ is -C₆H₂S₂-.

In step S02, the catalyst is an organic palladium catalyst, and the amount of the catalyst is 0.1-20% of the molar amount of compound A. The organic palladium catalyst may be, but not limited to Pd₂(dba)₃/P(o-Tol)₃, Pd(PPh₃)₄ or Pd(PPh₃)₂Cl₂. The alkaline solution may be an inorganic or organic alkali solution. The inorganic alkali solution may be aqueous solutions of alkali metal hydroxide or alkali metal carbonate, for example, but not limited to, solution of sodium hydroxide, potassium hydroxide solution, sodium carbonate solution, potassium carbonate solution, etc., preferably, sodium carbonate solution. The organic alkali solution may be aqueous solutions of alkyl hydroxide, ammonium hydroxide solution, for example, but not limited to, tetramethyl ammonium hydroxide, tetraethyl ammonium hydroxide, tetrapropylammonium hydroxide, ammonium, tetrabutyl ammonium hydroxide. The amount of the alkaline solution may be 1-10 times of the molar amount of the compound A. The solvent is a weak-polar aprotic organic solvent or a polar aprotic organic solvent or their mixtures, for example, but not limited to chloroform, methylene chloride, ethylene glycol dimethyl ether, dimethyl sulfoxide (DMSO), tetrahydrofuran (THF), toluene, xylene, or similar compounds, preferably toluene. The amount of the solvent is sufficient to make sure the various reactants are dissolved and adequate responsed.

The reaction in step S02 is illustrated in the following scheme (i):

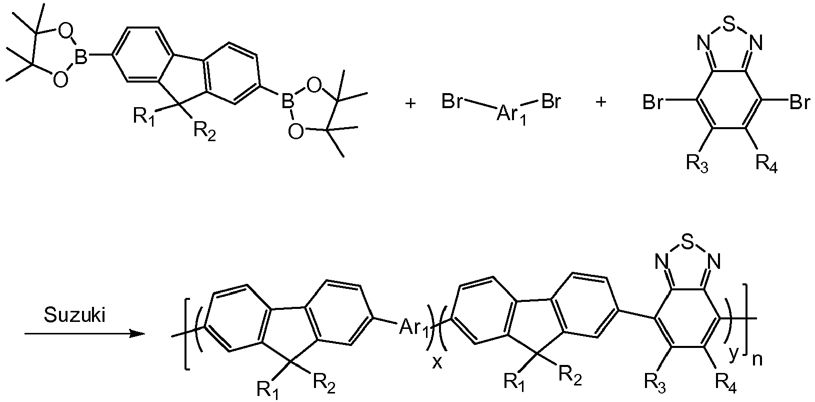

The reaction temperature of the Suzuki polymerization is 30°C-150°C, preferably 80-140°C, more preferably 130°C; and the reaction time is 1-7 days, preferably 2-5 days, more preferably 3 days. Preferably, the step S02 is carried out under a nitrogen atmosphere. In detail, after adding the various the raw materials and reagents, nitrogen is inlet for 0.5-3 hours to replace air, the mixture is heated to reflux, and reaction continues for 1-5 days, and then bromobenzene is added at the reflux state, after 6-24 hours, phenylboronic acid is added and the reaction continues for 6 -24 hours to obtain the product.

In addition, the method further includes a purification step to the reaction product, which includes the following steps: the solvent is removed by reducing pressure; the product is extracted with chloroform/water; washed; dried; the chloroform is removed by reducing pressure; the product is deposited with methanol; pumping filtrated to obtain deposition; the deposition is purified through alumina column chromatographic separation using chloroform as eluent; the product is rotary evaporated; deposited with methanol; pumping filtrated to obtain solid; Soxhlet extracted for three days with acetone; deposited with methanol; pumping filtrated to obtain deposition; vacuum dried; the deposition is filtered and the solid conjugated fluorene polymer is obtained. In detail, the purification step may include the following steps: the solvent is removed by reducing pressure; the product is extracted with chloroform/water; washed with saturated salt water, dried with anhydrous sodium sulfate. The chloroform is removed from the dried product by reducing pressure, and the product is deposited with methanol and pumping filtrated to obtain deposition. The deposition is purified through alumina column chromatographic separation using chloroform as eluent, the product is rotary evaporated; deposited with methanol; pumping filtrated to obtain solid; Soxhlet extracted for three days with acetone; deposited with methanol; pumping filtrated to obtain deposition; vacuum dried; the deposition is filtered and the solid is obtained with the yield is about 60%-85%.

In the preparation method described above, the synthesis routes of three monomer A, B, and C are relatively simple and mature, which are basically one step synthesis, thereby reducing the manufacturing costs. In addition, Suzuki polymerization reaction is mature polymerization of high yield and under mild conditions, easy to control, and the solubility and molecular weight of the product is increased by the introduction of alkyl, such that a spin-coating polymer is realized.

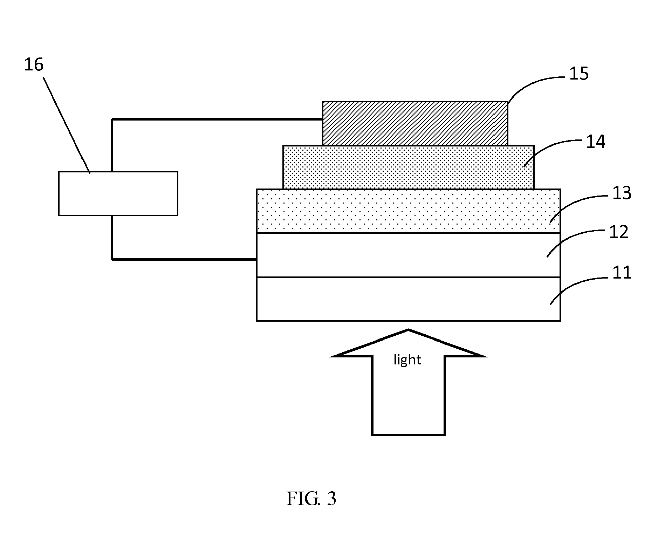

Referring to FIG. 3, a solar cell device including the conjugated fluorene polymer includes a glass substrate 11, a transparent anode 12, a middle auxiliary layer 13, an active layer 14, and a cathode 15, which are laminated in this order. The middle auxiliary layer 13 is made of a composite material of poly(3,4-ethylenedioxythiophene): poly(styrenesulfonate) (PEDOT:PSS). The active layer 14 includes electron donor materials and electron acceptor materials; the electron donor material is the conjugated fluorene polymer; the electron acceptor material may be [6,6]-phenyl-C₆₁-butyric acid methyl ester (PCBM). The transparent anode 12 may be indium tin oxide (ITO), preferably ITO having a sheet resistance of 10∼20Ω/sq. The cathode 15 may be aluminum electrodes or two-metal layer electrode, such as Ca/Al or Ba/Al layer electrode. In preparation, the glass substrate 11 may be the base, an ITO glass was selected and ultrasonic cleaned, and then oxygen-plasma treated. The middle auxiliary layer 13 was coated on the ITO glass, then the conjugated fluorene polymer and the electron acceptor material were mixed and coated on the middle auxiliary layer 13 to form the active layer 14. Next, the cathode 15 was deposited on the active layer 14 by vacuum evaporation technology, and the solar cell device was obtained. In one embodiment, the thickness of the transparent anode 12, the middle auxiliary layer 13, the active layer 14, and Ca/Al layer electrode are 160 nm, 40 nm, 150 nm, 20 nm, and 70 nm, respectively.

As illustrated in FIG. 3, when the solar cell device is irradiated, the light goes through the glass substrate 11 and the ITO electrode 12, the conjugated fluorene polymer in the active layer 14 absorbs solar energy and forms exciton. The exciton will be migrated to the interface between the electron donor materials and the electron acceptor materials, and electrons are transferred to the electron acceptor material, such as PCBM, such that the separation of the charge is realized, and the free carriers, i.e. free electrons and holes, are formed. The free electrons are passed to the metal cathode along the electron acceptor material and are collected by the cathode; the free holes is passed to the ITO anode along the electron donor materials and is collected by the anode, such that the photocurrent and photovoltage are formed and photoelectric conversion is achieved. When the solar cell device is connected to a load 16, the solar cell device may supply power to the load 16.

Since the polymer has a thienyl group and fluorene, which are both excellent electron donor materials, and benzothiadiazole base is a very excellent electron acceptor material, the conjugated fluorene polymer can form a strong electron donor-acceptor structure, which on the one hand can increase the stability of the material, on the other hand can narrow the bandgap of the material due to the effect between the electron donor and the electron acceptor, thus expanding of sunlight absorption range and improving the efficiency of photoelectric conversion. Furthermore, these introduced groups have a large ring and/or fused ring structure, thus they can increase the electron density of the polymer backbone, such that the absorption spectrum of the conjugated fluorene polymer can be adjusted in a wide range, which makes such materials can have a wider spectral response range. When the polymer is applied to optoelectronic materials, they can better match the solar emission spectrum, and make full use of solar energy, and increase the electricity production capacity of solar cell devices. Moreover, this organic material can reduce the weight of the solar cell device, and thus facilitating the mass production.

In addition, the conjugated fluorene polymer not only can be applied to solar cell devices, but also can be applied to organic field-effect transistors, organic electroluminescent devices, organic optical storage devices, organic nonlinear materials or organic laser devices, etc..

A preferable example is provided for illustrate certain aspects of the preparation method of the conjugated fluorene polymer and its performance. The compounds A, B, and C, in the embodiment can be prepared accordingly or can also be purchased directly from the market.

Step 1, the compound A was prepared. In this embodiment, the compound A is 2, 7 - bis (4, 4, 5, 5 - tetramethyl -1, 3, 2 - dioxaborolan-2-yl) -9, 9 - dioctylfluorene, which has a formula as:

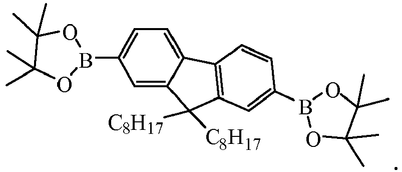

The detailed preparation was described as follows. At a temperature of -78°C and nitrogen atmosphere, 1.44ml (4.20 mmol) of butyl lithium solution was added to a two-neck flask containing 1.10 g (2.00 mmol) of 2,7 - dibromo -9, 9 - dioctylfluorene and 20 ml of tetrahydrofuran with a syringe, the mixture was stirring for 10 minutes and the temperature was raised to 0°C, next the mixture was stirred for 20 minutes. When the temperature was dropped to -78°C, 1.00 ml (4.80 mmol) of 2 - isopropoxy-4, 4, 5, 5 - tetramethyl-1, 3, 2-dioxaborolane was added with a syringe. The temperature was raised to room temperature and the mixture was stirred for 24 hours. After the reaction, the reaction mixture was poured into water, extracted by ether, washed with brine once, dried with anhydrous magnesium sulfate, the filtrate was collected by rotary evaporation. The filtrate was then purified by silica gel column chromatography using petroleum ether/ethyl acetate (9/1) as eluent, and the product was obtained by recrystallization with diethyl ether/methanol with the yield of 75%.

Test results were: MALDI-TOF-MS (m/z): 642.5 (M⁺).

Step 2, the compound B was prepared. In this embodiment, the compound B is 2, 5 - dibromo-thiophene [3, 2-b] thiophene, which has a formula as:

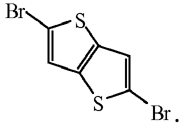

The detailed preparation was described as follows. Under an ice bath and dark conditions, 2.15g (12.1mmol) of NBS and 10 ml of DMF were added to a two-neck flask containing 0.84 g, (6.00 mmol) of thieno[3,2-b]thiophene, and 20 ml of DMF, the mixture is stirred for 4 hours. After the reaction, the reaction mixture was poured into ice water to quench, extracted with dichloromethane, and then washed once with deionized water, dried with anhydrous magnesium sulfate, the filtrate was collected by rotary evaporation. The filtrate was then purified by neutral alumina column chromatography separation, and light yellow solid product was obtained with the yield of 81%.

Test results were: MALDI-TOF-MS (m/z): 298.1 (M⁺).

Step 3, the compound C was prepared. In this embodiment, the compound C is 4, 7 - dibromo-2, 1, 3 - benzothiazole, which has a formula as:

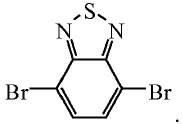

The detailed preparation was described as follows. 13.6g (100.00mmol) of benzothiadiazole was dissolved in 20 ml of hydrobromic acid with a concentration of 45%, and the mixture is heated and stirred to reflux, 48g (300.00mmol) of bromine was added in drops. After the addition of the bromine, 10 ml hydrobromic acid was added and the reflux reaction continued for 3 hours. The reaction mixture was filtrated when it was hot, cooled, filtrated, water washed, dried, and recrystallized with chloroform, such that solid product is obtained with a yield of 82%.

Test results were: MALDI-TOF-MS (m/z): 293.9 (M⁺).

Step 3, the conjugated fluorene polymer is prepared. In this embodiment, the conjugated fluorene polymer has a formula as:

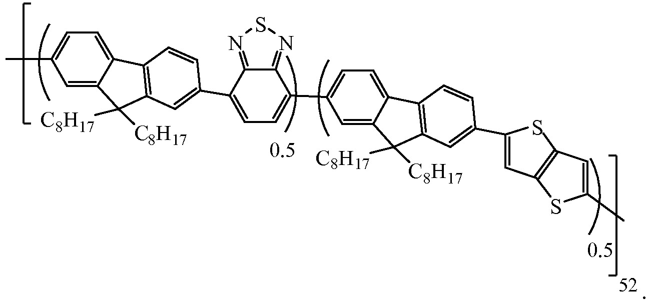

The detailed preparation was described as follows. Under a protection of the nitrogen, 10 ml Na₂CO₃ (2M) aqueous solution and toluene (20 ml) were added to a reactor containing 0.321g (0.50 mmol) of 2,7-bis(4, 4, 5, 5 - tetramethyl-1, 3, 2-miscellaneous oxygen amyl boron alkyl) - 9, 9 - dioctyl fluorene, 0.0745g(0.25 mmol) of 2, 5 - dibromo-thiophene [3, 2-b] thiophene, 0.0735g (0.25 mmol) of 4, 7 - dibromo-2, 1, 3 - benzothiadiazole 0.00416 g, (0.0036mmol) of Pd (PPh₃)₄. After nitrogen was inlet for 1 hour to replace air, the mixture was heated to reflux and reaction continued for 48 hours. After adding 0.0942g (0.60 mmol) of bromobenzene under reflux state to react for 12 hours, 0.0793g (0.65 mmol) of phenylboronic acid was added to continue react for 12 hours. The reaction product was decompressed to remove toluene, extracted with chloroform/water, washed with saturated salt water, dried with anhydrous sodium sulfate. The pressure of the reaction product was reduced to remove considerable toluene until 3-5 ml of solution was left, then the solution was deposited with methanol and pumping filtrated to obtain deposition. The deposition is purified through alumina column chromatographic separation using chloroform as eluent, the product is rotary evaporated; deposited with methanol; pumping filtrated to obtain solid; Soxhlet extracted for three days with acetone; deposited with methanol; pumping filtrated to obtain deposition; vacuum dried and the product is obtained with the yield is about 74%.

Test results were: GPC:Mn=28300, PDI=1.6.

In the conjugated fluorene polymer, the fluorene or its derivatives have excellent optical and thermal stability. Since the thiophene groups are introduced in the polymer main chain, and the thiophene has a five-membered ring structure, which matches the Huckel rule and has moderate energy band gap, wide spectral response, better thermal stability and environmental stability, the spectral response range of the polymer becomes wider. Meanwhile, benzothiadiazole groups, which have a five-membered ring structure and a conjugated dienes structure, are introduced in the polymer main chain. The benzothiadiazole groups not only can have similar performance of the thiophene, but also can function as a conjugated dienes structure, thus further widen the spectral response range of the polymer. In addition, these introduced groups have a large ring and/or fused ring structure, thus they can increase the electron density of the polymer backbone, such that the absorption spectrum of the conjugated fluorene polymer can be adjusted in a wide range, which makes such materials can have a wider spectral response range. When the polymer is applied to optoelectronic materials, they can better match the solar emission spectrum, and make full use of solar energy. In the preparation method of the conjugated fluorene polymer, a relatively simple synthetic route (basically a step synthesis) is used, thereby reducing the process and the manufacturing costs. Due to the use of the conjugated fluorene polymer, the solar cell device can not only increase the photoelectric conversion efficiency, but also reduce the weight of solar cell devices, and thus facilitating the mass production.

Although the invention has been described in language specific to structural features and/or methodological acts, it is to be understood that the invention defined in the appended claims is not necessarily limited to the specific features or acts described. Rather, the specific features and acts are disclosed as sample forms of implementing the claimed invention.

## Claims

1. A conjugated fluorene polymer, comprising a polymer represented by formula (1): 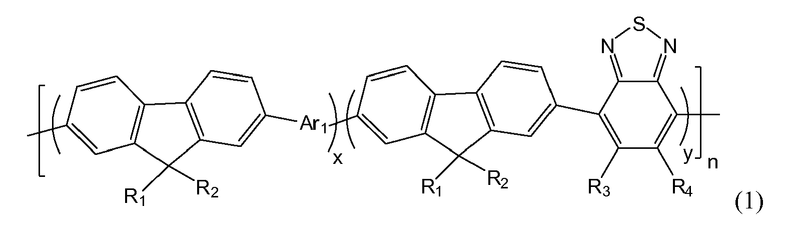 wherein R₁, R₂, R₃, R₄, which may be identical or different, represent H or C₁-C₂₀ alkyl, x+y=1, x≠0, y≠0, n is a natural number between 1-1000, Ar₁ is a group containing thiophene.

2. The conjugated fluorene polymer according to claim 1, wherein x=20%-80%, y=20%-80%.

3. The conjugated fluorene polymer according to claim 1, wherein R₁ and R₂ are C₈H₁₇, and R₃ and R₄ are H.

4. The conjugated fluorene polymer according to claim 1, wherein Ar₁ is selected from the group consisting of following formulas: 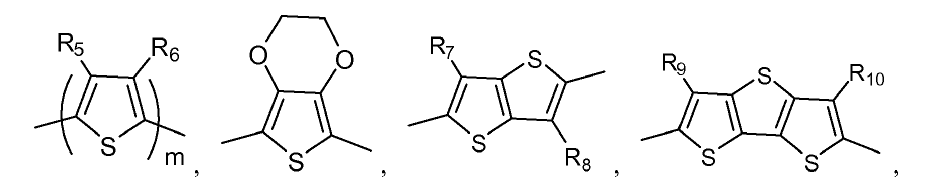 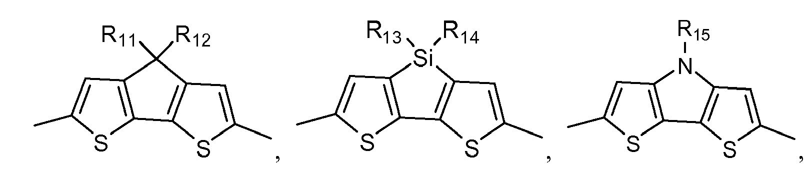 wherein R₅, R₆, R₇, R₈, R₉, R₁₀, which may be identical or different, represent H or C₁-C₂₀ alkyl; and R₁₁, R₁₂, R₁₃, R₁₄, R₁₅, which may be identical or different, represent H or C₁-C₂₀ alkyl; and m is a natural number between 1-20.

5. The conjugated fluorene polymer according to claim 1, wherein Ar₁ is a group represented by 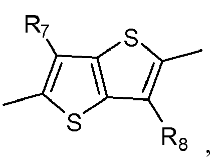 wherein R₇ and R₈, which may be identical or different, represent H or C₁-C₂₀ alkyl.

6. A preparation method of a conjugated fluorene polymer, comprising the steps of:
providing compounds A, B, and C represented by formulas: 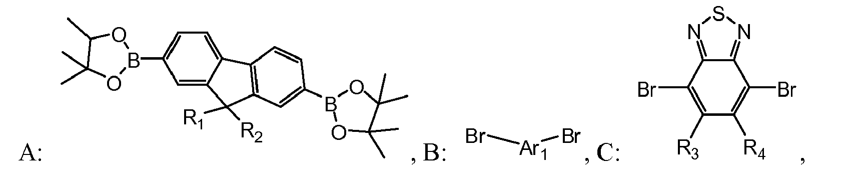 wherein R₁, R₂, R₃, R₄, which may be identical or different, represent H or C₁-C₂₀ alkyl, x+y=1, x≠0, y≠0, Ar₁ is a group containing thiophene; and Suzuki polymerizing the compounds A, B and C in the presence of a catalyst, a solvent and an alkaline solution to obtain a polymer represented by formula (1): 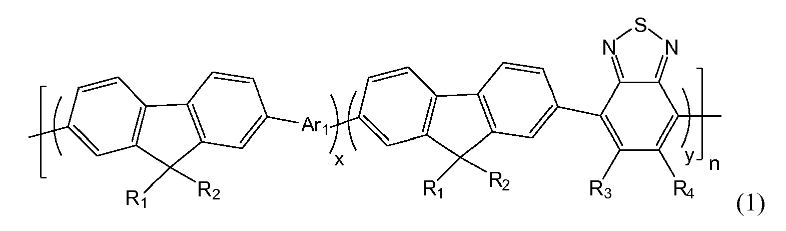 wherein n is a natural number between 1-1000.

7. The preparation method according to claim 6, further comprising purifying the reaction product according to the following steps: removing the solvent by reducing pressure; extracting with chloroform/water; washing; drying; removing the chloroform by reducing pressure; depositing with methanol; pumping filtrating to obtain deposition; purifying the deposition through alumina column chromatographic separation using chloroform as eluent; rotary evaporating; depositing with methanol; pumping filtrating to obtain solid; Soxhlet extracting for three days with acetone; depositing with methanol; pumping filtrating to obtain deposition; vacuum drying; filtering the deposition and obtain the solid conjugated fluorene polymer.

8. The preparation method according to claim 6, wherein the reaction temperature of the Suzuki polymerization is 30°C-150°C; the reaction time is 1-7 days.

9. The preparation method according to claim 6, wherein the catalyst is an organic palladium catalyst; and the alkaline solution is an inorganic alkaline aqueous solution or an organic alkaline aqueous solution, the solvent is a weak-polar aprotic organic solvent or a polar aprotic organic solvent or mixtures thereof.

10. A solar cell device, comprising: a glass substrate, a transparent anode, a middle auxiliary layer, an active layer and a cathode, which are laminated in this order, the active layer comprising electron donor materials and electron acceptor materials, wherein the electron donor material is the conjugated fluorene polymer according to any one of claims 1 to 5.
